Europäisches Patentamt

European Patent Office

Office européen des brevets

(11) Publication number: **0 080 857**
**A1**

# EUROPEAN PATENT APPLICATION

(21) Application number: **82306248.4**

(22) Date of filing: **24.11.82**

(51) Int. Cl.³: **H 02 H 3/04**
**G 01 R 31/02**

(30) Priority: **26.11.81 GB 8135784**

(43) Date of publication of application:
**08.06.83 Bulletin 83/23**

(84) Designated Contracting States:
**IT**

(71) Applicant: **British Nuclear Fuels Limited**

**Risley Warrington Cheshire, WA3 6AS(GB)**

(72) Inventor: **Wilbraham, Paul Kevin**
**131 Long Lane**
**Upton-by-Chester Chester Cheshire(GB)**

(72) Inventor: **Sayers, Martin Richard**
**26 Fownhope Avenue**
**Sale Greater Manchester(GB)**

(74) Representative: **Dunnill, Laurence Arthur**
**Patents Branch United Kingdom Atomic Energy**
**Authority 11 Charles II Street**
**London SW1Y 4QP(GB)**

(54) A device for testing circuit breakers.

(57) A device for testing earth leakage circuit breakers detects the time period (T) between a fault being introduced between a current carrying circuit and earth and the circuit breaker interrupting the current flow, a time delay (t) being introduced to the sampling in order to avoid false indication of contact breaker opening upon zero crossing. The time delay occurs at the start of earth leakage as well as at the end of earth leakage, so that no error is introduced.

Fig .2.

EP 0 080 857 A1

TITLE: A DEVICE FOR TESTING CIRCUIT BREAKERS

This invention relates to a device for testing circuit breakers.

High sensitivity earth leakage (HSEL) or as otherwise known, residual current, circuit breakers are used for protecting the users of electrical equipment from electrical shock if there is a leakage of current from supply lines to earth. A widely used system is the current or voltage operated system which automatically disconnects the supply if earth leakage occurs. If the user is to be adequately protected, it is necessary for the mains supply to be disconnected in a very short time and for a supply to be disconnected at a very low leakage current (thirty milliseconds and ten milliamps).

According to the present invention, a device for testing circuit breakers comprises:

switch means for connecting an alternating current supply to earth,

a gating system connected to the switch means and connected to control timing means, said gating system being arranged to actuate the timing means to measure the time period between connection of the supply to earth and opening of the earth leakage circuit breakers, characterised in that

the gating means comprises means for differentiating between opening of the circuit breakers and supply cross-over.

The switching means may be associated with resistors of varying values to limit the current flowing to earth. If this is the case, variation of the resistor value enables the device to check the circuit breakers for various values of leakage current so that the device is usable with different types of circuit breaker. Means may be provided for determining the polarity of the supply when earth leakage begins.

The timing means may comprise a crystal controlled oscillator. Conveniently, a one megahertz or a one hundred kilohertz frequency oscillator is used, giving a timing impulse every millisecond by division.

Preferably, said means for differentiating comprises a time compensation circuit. Advantageously, the time compensation circuit is adjusted so that its output switches for a greater period of time than the period of time detected as no current owing to zero cross-over of the input. Advantageously, the time compensation circuit comprises a programmable inverter, a monostable multivibrator and a coincidence detector. The output of the coincidence detector may control switching of the timing means, whereby the latter is not actuated by zero cross-over.

Preferably, the period of the monostable multivibrator is less than the period between zero cross-overs of the input, and also less than the desired opening time of the circuit breaker.

Advantageously, the programmable inverter is used to ensure that the monostable multivibrator responds in an identical manner at the start and completion of the test in order to remove errors due to changes in the monostable. Conveniently, the programmable inverter comprises a NOR gate.

An embodiment of the present invention will now be described, by way of example only, with reference to the accompanying drawings, in which:

Figure 1 is a block electrical circuit diagram,

Figure 2 is a diagram showing leakage current and logic values occurring in the device of the present invention, and

Figures 3a and 3b are a detailed circuit diagram of Figure 1.

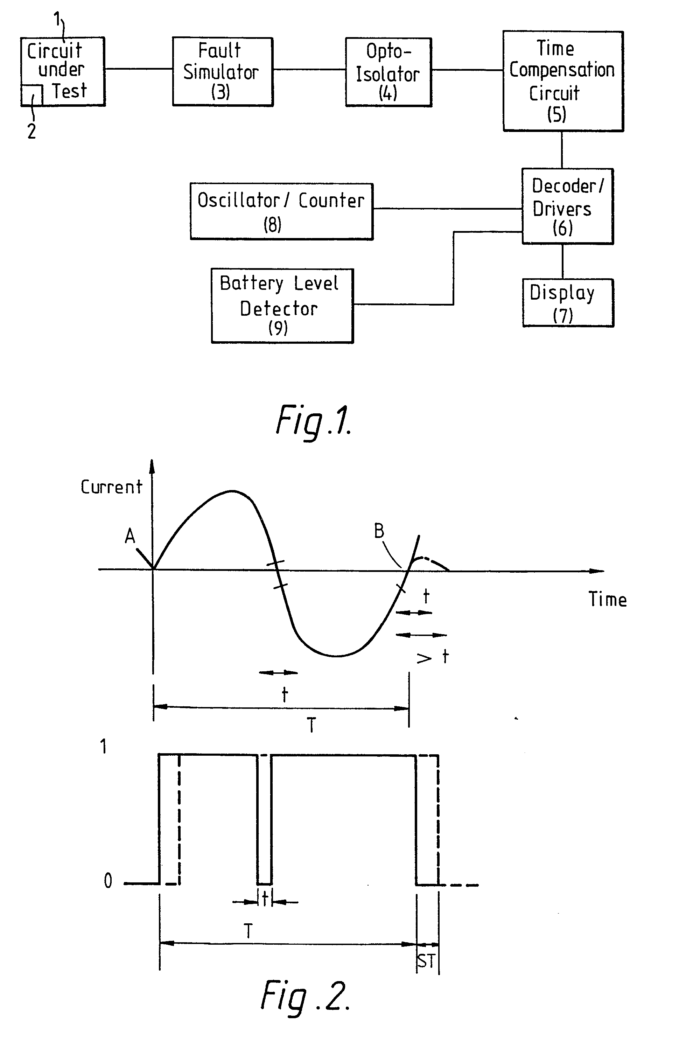

Reference is directed firstly to Figure 1, in which there is shown a circuit 1 under test. The circuit 1 includes current-operated high-sensitivity earth-leakage

4

circuit breakers 2 (also known as residual current circuit breakers). The circuit 1 and the circuit breakers 2 are outside of the testing device which includes the remaining components described with reference to Figure 1.

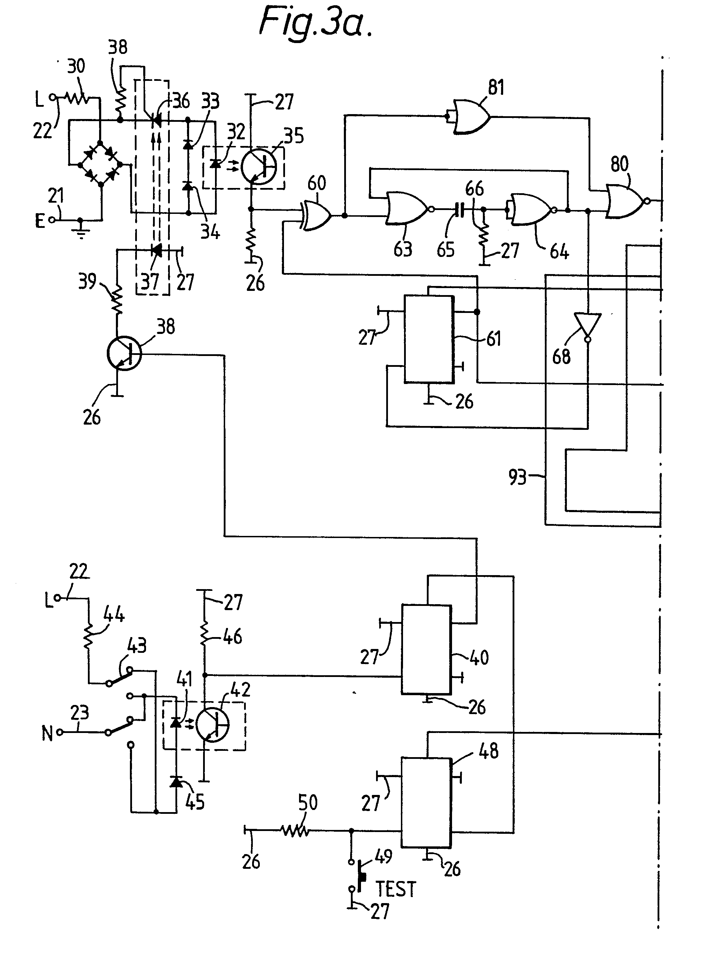

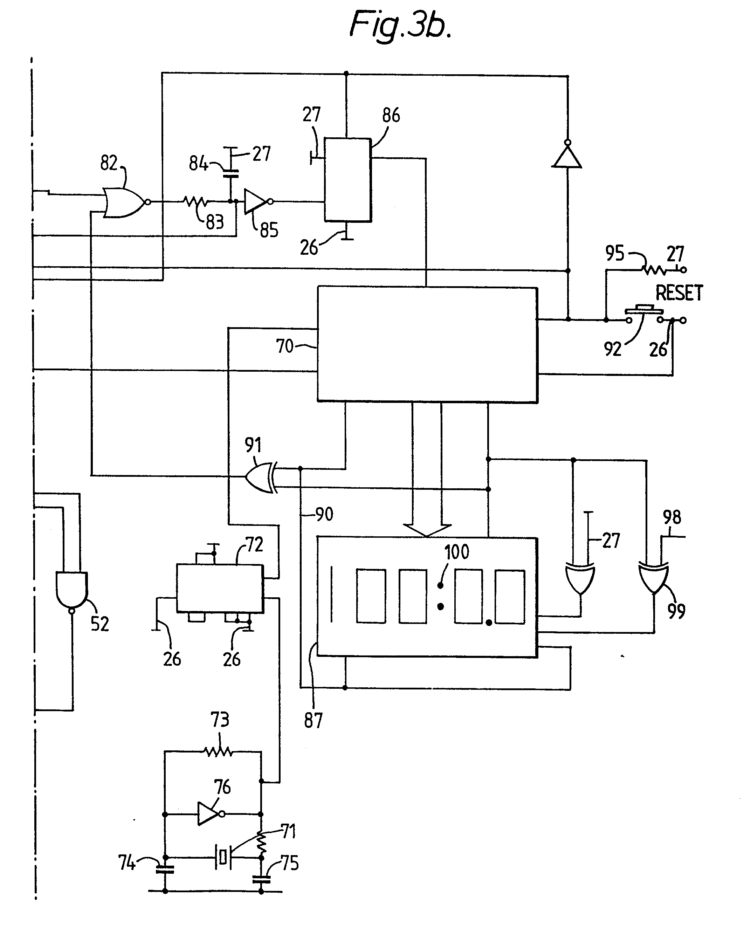

A fault simulator is indicated by 3, an optoisolator by 4 and a time compensation circuit by 5. The fault simulator 3 includes a line, of appropriate resistance to provide an appropriate leakage current, between alternating current supply lines in the circuit 1 and earth. The value of resistance may be changed in order to define various leakage currents and to allow the equipment to be used with various types of circuit breaker. Leakage current in this line is via optoisolator 4, which is used in order to provide a 2.5 kilovolt insulation between the circuit under test (an AC mains supply) and low voltage circuits in the testing device. The fault simulator 3 includes diodes (see Figure 3) whereby the polarity of the voltage waveform at the instance of fault application can be determined by an operator.

The optoisolator 4 is connected to the time compensation circuit 5, which comprises a monostable multivibrator, a programmable inverter and a coincidence detector. The optoisolator provides a high (logic 1) signal when earth leakage current is flowing. The time compensation circuit 5 passes the logic signal from the optoisolator 4 to a decoder and display driver circuit 6, which in turn is connected to driver display 7. A timing means comprising an oscillator and counter arrangement 8 (see Figure 3) is connected to the decoder/driver circuit 6. The oscillator is a one megahertz crystal oscillator which is divided down by the counter to give a ten kilohertz output, thus providing a timing pulse for the decoder every tenth of a millisecond. The display 7 is connected so as to display a time which is indicative of the time period while the output from the time compensation circuit was logic high, that is the time between connection of the supply to earth and opening of the earth leakage circuit breaker, thus allowing the decoder driver to pass the timing signal to the display. A battery level detector circuit 9 causes an indication to be given on display 7 when battery voltage falls below a pre-selected level, such as by causing the display to flash or by causing a colon to be displayed.

The fault simulator 3 may be considered as a switch means for connecting supply voltage to earth. The time compensation circuit 5 together with the decoder/driver circuit 6 may be considered as a gating system. The display 7 in associating with the oscillator/counter 8 may be considered as a timing means.

The time compensation circuit is selected to have a period which is:

(i) greater than the time taken for the optoisolator output to fall from high to low and then low to high in response to the zero cross-over point in the alternating current cycle in the circuit under test, and

(ii)   substantially less than the desired time for the contact breaker 2 to open and less than the period between zero cross-overs of the input.

For example, the time compensation circuit may switch if its input logic switches for a period which exceeds two milliseconds, which is greater than the zero cross-over time, but substantially less than the desired contact breaker opening period which is twenty milliseconds, or zero cross-over period of ten milliseconds.

In effect, the gating system is arranged to actuate the timing means to measure the time period between connection of the supply to earth and opening of the earth leakage circuit breaker. A delay in actuation of the timing means occurs when the fault current first flows, owing to the switching time of the time compensation circuit, but this delay is offset by a corresponding delay after the circuit breaker opens.

Operation of the time compensation circuit 5 is now described in more detail with reference to Figure 2. The upper part of Figure 2 shows a graph with current in the circuit under test plotted as ordinate and time as abscissa. The wave form may typically represent a fifty hertz alternating current mains. In this case, the time for one cycle is twenty milliseconds, that is from point A to B on the graph. The time for one cycle is indicated by T. In this particular example, T happens to be also the maximum desired opening time for the contact breakers. Of course, the maximum desired opening time for the contact breakers could be greater or lesser than T, in other embodiments.

Zero cross-over of the current wave form is detected as no current flowing during a period t as indicated on the first cross-over in the graph. The time period t is less than the period T by at least an order of magnitude.

Reference is now directed to the lower part of Figure 2, which shows with a full line the logic signal which is fed into the time compensation circuit 5 from the optoisolator 4. From the Figure, it can be seen that the logic goes from low(0) to high (1) at point A when earth leakage current first begins to flow. The logic stays high until the zero cross-over point where it goes low for a period t, then returns high until point B when it again goes low. The output from the time compensation circuit is shown dotted. The output starts low and does not go high until the period t after the input logic goes high, however, after having gone high, it stays high until the period t after the input logic has gone low for the second time. Therefore, although the input logic is "fooled" by the zero cross-over point, the output logic is not so fooled because of the switching time needed for the time compensation circuit. The reason why the output logic lags the input logic when it does switch is again owing to the effect of the switching period of the time compensation circuit. However, since a delay is added to both switching operations, accuracy of measurement of the switching time of the contact breakers is not affected. It should be appreciated, that the curve showing current in Figure 2 is drawn in the way it is for convenience. There could be a number of zero cross-over points occurring during the desired time for opening the contact breakers. Also, earth linkage could begin at any specified point in the current cycle to be tested and whether the beginning occurs in the positive or the negative part of the cycle can be selected by an operator of the device.

Reference is now directed to Figure 3, which shows the circuitry of the device in more detail. A plug (not shown) connects a line 21 to the earth line (not shown) of the supply under test and likewise line 22 to the live line and line 23 to the neutral line. The plug is connected into a socket (not shown) which is supplied by the main supply and a high sensitivity earth leakage (residual current) circuit breaker (not shown) is incorporated in the mains supply. The device of Figure 3 is powered by a DC power supply which throughout the Figure has a positive rail indicated by 26 and a negative rail indicated by 27. The supply could be a dry cell battery or it could be a rechargeable battery.

The mains supply is fed via a resistor 30 to a rectifying bridge 31. The resistor 30 could be a variable resistor or an adjustable resistor network, whereby the value of leakage current can be precisely defined and/or the equipment be made compatible with differing types of circuit breakers having different characteristics. The output from the rectifying bridge 31 is arranged to power a light-emitting diode 32. Clamping diodes 33 and 34 are provided to shunt the light-emitting diode 32 in order to protect the LED. The light-emitting diode 32 is part of an optoisolator, which has an associated transistor 35. The light-emitting diode 32 is only able to conduct when a silicon-controlled rectifier 36 is fired. The silicon-controlled rectifier 36 is optically-fired by a light-emitting diode 37, a resistor 38 being shown in the trigger line of the SCR.

The light-emitting diode 37 can only conduct when a transistor 38 conducts, in this situation a current passing through the LED 37, a resistor 39 and the transistor 38. The transistor 38 conducts when a signal appears on its base from a flip-flop 40, ie when the Q output of the flip-flop 40 is triggered to the high state.

The flip-flop 40 is triggered into the high state at zero cross-over of the input via an optoisolator comprising a light-emitting diode 41 and a photo-transistor 42. A switch 43 is utilised to select positive or negative cycle operation, a resistor 44 being in the live line and a diode 45 being in series with the LED 41. A resistor 46 is connected between the collector of transistor 42 and supply line 27. Flip-flop 40 is, however, only allowed to change to the high state if a re-set line controlled by flip-flop 48 is low. For this purpose, the flip-flop 48 has to be triggered by operation of a "test" push-button, which is indicated by 49. A resistor 50 is shown between supply 26 and flip-flop 48. Of course, the flip-flop 48 cannot have a low output unless it has been re-set. The circumstances for re-set of the flip-flop 48 will be outlined below, but the re-set line is from a nand gate 52.

Once leakage has begun, the transistor 35 conducts. Therefore, the emitter of the transistor is high (logic 1). When the circuit breaker opens, then the emitter of the transistor goes low (logic 0). The logic signal from the emitter of the transistor 35 goes to integrated circuit 60, which is a programmable inverter in the form of an EXCLUSIVE OR GATE set to its non-invert mode by a flip-flop 61. The output of the programmable inverter 60 goes to a monostable multivibrator formed from nor gates 63 and 64, timing being provided by capacitor 65 and resistor 66. Once the transistor 35 has been energised, the monostable mutlivibrator is started and produces a pulse at the output of nor gate 64.

The falling edge of the pulse at the output of nor gate 64, which occurs after delay t, triggers the clock of flip-flop 61 via inverter 68. The output of flip-flop 61 alters the programmable inverter 60 into inverting mode and at the same time removes the clock inhibit signal from a counter 70, which then starts counting. The counter clock signal is derived from a crystal-controlled oscillator 71 via a divider 72 to give pulses at 0.1 millisecond intervals. The crystal-controlled oscillator includes a resistor 73, capacitor 74 and 75 and an inverter 76.

The programmable inverter 60 is now in an inverting mode and causes the monostable multivibrator 63, 64 to be triggered when the transistor 35 is de-energised (ie during mains zero cross-over or when the circuit breakers open).

At zero cross-over, the output of the programmable inverter 60 will be a pulse, the start of which triggers the monostable multivibrator 63, 64. This pulse is also routed to a coincidence detector 80 (a nor gate), via an inverter 81, the pulse being compared with the monostable output pulse (t) in the coincidence detector.

If the monostable pulse is longer than the cross-over pulse, then no action occurs at the output. If the circuit breaker opens, then the state of the output of the inverter 81 will cause the monostable pulse t to appear at its output. The falling edge of this pulse passes through an overflow/stop gate 82. The output of the overflow/stop gate 82 incorporates a delay network formed from a resistor 83 and a capacitor 84, the delay network removing transmission delays. The falling edge is inverted by inverter 85 so that integrated circuit 86 can be triggered. When the output of integrated circuit 86 changes, the store line of counter 70 is set and the current data in the counter is frozen so that a display 87, driven by the counter 70, indicates the circuit breaker opening time. When the circuit breakers open, flip-flop 48 is re-set from the output of the overflow/stop gate 82 via nand gate 52. Re-setting can also occur if the counter 70 should overflow, since in this situation a half-digit signal passes from the counter to operate the half digit on the display 87 via line 90, the same signal being gated via back-planing gate 91 into an input of the overflow/stop gate 80. Consequently, if overflow should occur, then a one appears on the display and the device is re-set, since the circuit breakers have failed to open.

The flip-flop 48 can also be re-set by operation of a re-set button 92, which re-sets the counter and which causes a re-set signal to pass down line 93, thence through gate 52 to the flip-flop 48. A resistor 95 is connected between the re-set terminal and the negative supply rails. A battery test circuit, which is not shown in detail in this Figure, feeds a signal via line 98 to nor gate 99 to cause a colon 100 on display 87 to flash when low-battery voltage is detected.

From the foregoing, it can be appreciated that in operation of the device, the switch 43 can be used to detect whether earth leakage is to begin on the positive or negative half cycle, and upon actuation of the switch 49, the time period until the circuit breakers open is detected,

13

the time-compensation circuit causing the device not to be fooled by zero cross-over.  The device is re-set by the re-set button 92, or in the case where the circuit breakers fail to open.

From the above description, it can be seen that an improved device for testing circuit breakers is provided.

CLAIMS

1.    A device for testing circuit breakers comprising:

switch means for connecting an alternating current supply to earth,

a gating system connected to the switch means and connected to control timing means, said gating system being arranged to actuate the timing means to measure the time period between connection of the supply to earth and opening of the earth leakage circuit breakers, characterised in that

the gating means comprises means for differentiating between opening of the circuit breakers and supply cross-over.

2.    A device as claimed in claim 1, in which the switching means is associated with resistors of varying values to limit the current flowing to earth.

3.    A device as claimed in claim 1, in which means is provided for determining the polarity of the leakage signal when earth leakage begins.

4.    A device as claimed in claim 1, in which said means for differentiating comprises a time compensation current.

5.    A device as claimed in claim 3, in which the time compensation circuit switches for a greater period of time than the period of time detected as no current because of zero cross-over.

6.    A device as claimed in claim 4, in which the time compensation circuit comprises a programmable inverter, a

2

monostable multivibrator and a coincidence detector.

Fig.1.

Fig.2.

# Fig.3a.

## Fig.3b.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| | --- | | H 02 H 3/04 |
| X,Y | GB-A-2 056 094 (KODAK) | 1-2,5-6 | G 01 R 31/02 |
| | *Abstract; page 1, lines 7-64,122-129; page 2, lines 1-87; figures 2-3c* | | |
| | --- | | |
| Y | GB-A-1 050 119 (ASSOCIATED ELECTRICAL INDUSTRIES LTD.) *Page 2, lines 95-113; figure 4* | 1 | |
| | --- | | |
| A | GB-A-2 049 204 (MADEWEL ELECTRONIC PRODUCTS LTD.) *Abstract; page 1, lines 6-55,69-115; figures 1,3* | 1 | |
| | ----- | | |

**TECHNICAL FIELDS SEARCHED (Int. Cl. ³)**

H 02 H
G 01 R

The present search report has been drawn up for all claims

| Place of search | Date of completion of the search | Examiner |
|---|---|---|
| THE HAGUE | 10-02-1983 | KUSCHBERT D.E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82